# EUROPEAN PATENT APPLICATION

(11) **EP 4 808 289 A1**
(43) Date of publication of application: **16.09.2026**
(21) Application number: 25163940.7
(22) Date of filing: 14.03.2025
(51) Int. Cl.: H05K 1/02, H05K 1/11, H05K 3/06, H05K 3/34, H05K 3/46

(54) **PRINTED CIRCUIT BOARD**

(71) Applicant: IMPERIAL TOBACCO LIMITED, Bristol BS3 2LL (GB)
(72) Inventor: HATTON, Kevin Paul, Bristol, BS3 2LL (GB); SMYTH, Andrea, Bristol, BS3 2LL (GB)
(74) Representative: Mewburn Ellis LLP

(57) **Abstract**

A printed circuit board (PCB) for an aerosol generating device is provided. The printed circuit board comprises: one or more power input terminals for receiving power from a power source, and one or more heater terminals for providing the power from the power input terminals to a heating system of the aerosol generating apparatus. A first outer layer of the printed circuit board comprises a plurality of signal traces and one or more copper pours. The first outer layer comprises: a first main zone comprising each of the one or more copper pours, and a first keep-out zone surrounding the one or more heater terminals, wherein the one of more copper pours are delineated by a perimeter between the first main zone and the first keep-out zone, and a shortest distance between the one or more heater terminals and the first main zone is at least 2mm.

## Description

### FIELD

The present disclosure relates to a printed circuit board for an aerosol generating device, and an aerosol generating device.

### BACKGROUND

A heat-not-burn (HNB) device, also known as a heated tobacco device, is a type of aerosol-generating system in which an aerosol precursor (e.g., a solid precursor such as tobacco) is heated by a heating system to produce an aerosol that can be inhaled by the user.

The heating system comprises a heating element which is located in proximity to the aerosol precursor to produce the aerosol and which receives power from circuitry in the HNB device. Typically the circuitry is provided as a printed circuit board (PCB) housed within a body of the HNB device. One or more heater terminals of the PCB are connected to the heating system via wires or other conductors.

In some examples, particularly when the device is subject to heavy use, the connection between the PCB and the heating element can provide a path for residue from the heating portion of the device body to leak towards the PCB. The residue may be any substance found in the heating portion of the device body, such as aerosol generating byproducts, the aerosol precursor, or other substances received in the heating portion from the environment. This can cause residue to build up on the PCB which can have undesirable thermal conduction properties causing damage to the PCB or operational faults. For example, the residue may contain glycerol, which is thermally conductive and cause overheating of the PCB and result in damage to the PCB over time. Example faults observed as a result of residue build-up include overheating one or more components of the PCB, detachment of solder pads from the PCB, failed solder joins, and failure of the PCB to provide power to the heating system.

Accordingly, there is a desire for a PCB for an aerosol generating device which is more reliable and robust when the device is subject to heavy use. It is against this background that the present invention has been developed.

### SUMMARY

Broadly, the present invention relates to a printed circuit board (PCB) for an aerosol generating device in which the PCB comprises a clearance zone. For example, the clearance zone may be located at a heating end of the PCB. Accordingly, if a fault event of the aerosol generating device happens proximal to the clearance zone a likelihood of the fault event affecting the operation of, or damaging, the PCB can be reduced. For example, the clearance zone may be an area of the PCB (e.g., a keep-out zone) with reduced numbers of components, signal tracks, and/or copper.

Further, the present invention relates to an aerosol generating device comprising a heating element connected to a PCB with a clearance zone. The clearance zone may surround a terminal of the PCB for connecting to the heating element. Therefore, contaminants leaking from the heater environment to the PCB may be less likely to cause damage to the PCB, PCB components, or the surrounding aerosol generating device.

Accordingly, in a general sense, the invention relates to a minimum separation distance between one or more connection terminals of a PCB (e.g., a heater terminal) for an aerosol generating device and one or more other features or components of the PCB. This separation distance can reduce a likelihood of faults occurring in the PCB.

In a first aspect, there is provided a PCB for an aerosol generating device, wherein the printed circuit board comprises: one or more heater terminals for providing power to a heating system of the aerosol generating device, wherein an outer layer of the PCB comprises: one or more copper pours, a main zone comprising each of the one or more copper pours, and a keep-out zone surrounding the one or more heater terminals. A shortest distance between the heater terminal and the main zone may be at least 2mm.

Advantageously, providing a keep-out zone around the heater terminals reduces a likelihood of damage to the PCB as a result of residue leaking from the heater environment to the heater terminals. By locating the one or more copper pours in the main zone, thermal conduction effects of such residue can be reduced thereby protecting other components on the PCB from overheating.

The PCB may be a laminated structure comprising one or more conductive and insulating layers. The PCB may be single-layer, double-layer, or multilayer PCB. In this context, a layer may be understood to refer to a conductive plane of the PCB (for example, formed of copper) which can be used to route electrical traces between components. The conductive layers may be separated from each other by one or more insulating layers which may also be referred to as a substrate, core, dielectric, or prepreg. The outer conductive layers of the PCB (e.g., the top and/or bottom conductive layers of the PCB) may be coated in solder mask, also known as solder resist, which protects the conductive traces and the interfaces between traces. The outer layers may optionally comprise silkscreen printed onto the solder mask for labelling components and regions on the PCB, and solder pads for mounting components or connectors of the PCB.

The first outer layer may be referred to as a top layer or bottom layer of the PCB, or top or bottom side of the PCB. The first outer layer may comprise a conductive plane formed of copper foil and a solder mask deposited onto the conductive plane. The conductive plane may be selectively etched to provide signal traces, which may optionally be separated by polygon pours (e.g., copper pours).

The printed circuit board may comprise a plurality of signal traces or tracks. A trace or track of the PCB may be understood to be a conductive pathway formed in a conductive plane of the PCB that acts as a route for electrical signals to travel between different components on the PCB. The traces may connect specific points on the PCB via individually routed pathways, in contrast to copper pours which may fill regions between the traces and may optionally provide a common connection point for multiple components without being individually routed towards each component.

A copper pour may be understood to be a continuous area of copper on the PCB. Each copper pour may be defined by a polygon shape and formed via etching of a copper layer during manufacture of the PCB. Each copper pour may be a section of a copper plane (e.g., conductive sublayer) which fills a region between signal traces of the PCB. Each copper pour may be electrically connected to a power or ground signal to form a power or ground plane. Accordingly, the one or more copper pours may also be referred to as a power planes, ground planes, or polygon pours.

The keep-out zone, which may be referred to as a clearance area or stand-off region, may be considered as a delineated exclusion or buffer zone where unnecessary components, traces, and/or copper pours (e.g., power planes) cannot be placed and so are absent. Necessary components in the keep-out zone may include the one or more heater terminals and necessary traces may include (only) one or more traces which are connected to the one or more heater terminals.

The keep-out zone may be a portion of the PCB which is absent of copper pours. Accordingly, the one or more copper pours of the first outer layer may be delineated by a perimeter between the main zone and the keep-out zone. Therefore, all power planes of the first outer layer may be located in the main zone. All copper in the keep-out zone, except for signal traces that are connected to the one or more heater terminals, may be etched away.

The main zone may be a remainder of the first outer layer in which copper pours, signal tracks, and components may be placed. Each copper pour (e.g., all copper pours) of the first outer layer of the PCB may be located in the main zone. Additionally, all components mounted to the first outer layer of the PCB, other than a component mounted to the one or more heater terminals, may be located in the main zone.

The outer layer may be a first outer layer. The PCB may comprise a second outer layer on an opposite side of the PCB to the first outer layer. The main zone may therefore be a first main zone, and the keep-out zone may be a first keep out zone, wherein the second outer layer comprises a second main zone and a second keep-out zone as discussed in more detail below.

The one or more heater terminals may include a positive terminal and a negative terminal. The power provided to the one or more heater terminals may be switched power which is selectively enabled and disabled to control a temperature of the heating system.

Each of the one or more heater terminals may each be a solder connection pad of the PCB. For example, the one or more heater terminals may be connectable to the heating system via one or more wires soldered to the solder pads or a heater connector which is mounted to the PCB via the one or more heater terminals. The one or more heater terminals may be surface mount or through-hole terminals of the PCB.

As mentioned above, a shortest distance between the heater terminal and the main zone may be at least a 2mm, more preferably at least 2.5mm, more preferably at least 3mm. The shortest distance may be referred to as a separation distance or a stand-off distance between the heater terminal and the main zone. Accordingly, the one or more heater terminals may be separated from the one or more copper pours or signal tracks located in the main zone by the separation distance. The one or more heater terminals may be separated from all components mounted to the first outer layer by at least the separation distance.

For example, the first outer layer of the PCB may comprise a copper layer forming a ground plane which fills regions between signal traces. Accordingly, the one or more heater terminals may be separated from a nearest ground plane of the first outer layer by at least the separation distance. By avoiding surrounding a terminal of the PCB with a ground plane, as in conventional PCB design, the PCB can be more resistant to thermal damage in an event of residue leakage from the heating element.

The keep-out zone may have a width of at least 3mm, more preferably at least 5mm, more preferably at least 6mm. The width of the keep-out zone may be measured in a direction parallel to a longitudinal axis of the PCB. A length of the keep-out zone, measured, perpendicularly to the width, may be at least 10mm, at least 12mm, or at least 15mm.

The PCB may include a stand-off distance between each of the one or more copper pours and tracks or pads of the PCB, which are not connected to the same electrical net as the copper pour. The copper pours may also be separated from the edges of the PCB by a stand-off distance. For example, a maximum stand-off distance of the PCB may be between 0.2mm and 1mm. A width of the keep-out zone may be larger than such stand-off distances. For example, a width of the keep-out zone surrounding the heater terminal, may be at least three times, more preferably at least five times larger than a largest stand-off distance between the copper pours and signal tracks of the PCB. In this way, the keep-out zone provides increased thermal insulation for protecting the PCB from over-heating, in addition to the electrical insulation provided by typical stand-off distances.

The PCB may comprise one or more power input terminals for receiving power from a power source. Thus, the heater terminal may be for providing the power from the one or more power input terminals to the heater. The one or more power input terminals may be located in or electrically connected to a terminal in the main zone of the first outer layer.

The one or more heater terminals may be separated from the one or more power terminals (which may be located on first or second outer layers of the PCB) by at least the separation distance. Accordingly, a likelihood of the power terminals being exposed to undesirable residue leaking from the heating system is reduced.

As mentioned above, the keep-out zone may be absent of copper pours. Traces formed of copper for providing power to the heater connector may be present in the keep-out zone. However, an overall proportion of the conductive plane covered by copper may be no more than a maximum percentage threshold for the keep-out zone.

For example, no more than 70%, no more than 50%, no more than 40% or no more than 30% of a surface area of the first outer layer in the keep-out zone may comprise copper. As mentioned above, the first outer layer may comprise a solder mask, and a selectively etched copper plane deposited onto a substrate. Therefore, no more than the maximum percentage threshold of a surface area of the selectively etched copper plane in the keep-out zone may comprise copper. That is, at least 30%, at least 50%, at least 60%, or at least 70% of the copper in the keep-out zone may be etched away so that the solder mask is deposited directly on the substrate in the etched regions.

The first outer layer may comprise one or more (active) components for operating the aerosol generating apparatus. Each of the one or more components of the first outer layer may be located in the main zone. In this way, the components can be separated from the heater terminal by the keep-out zone thus protecting the components from damage if residue from the heater builds up around the heater terminal. The one or more components may be additional components to the one or more heater terminals. The one or more additional components may comprise all additional components of the PCB which are mounted to the first outer layer of the PCB. Accordingly, all components mounted to the first outer layer may be positioned in the main zone. The components may include active components and/or connectors which are mounted to pads and/or mounting holes on the first outer layer. Accordingly, the first keep-out zone may comprise (only) the one or more heater terminals configured to connect to a heater and no other components.

In some examples, the one or more heater terminals may be one or more solder pads of the PCB (for receiving a connecting wire to the heater). Therefore, in these examples, all components mounted to the first outer layer may be located in the main zone and separated from the one or more heater terminals by at least the separation distance.

The first outer layer may comprise a plurality of traces for providing signals and/or power to the one or more components. Each of the plurality of traces may be located in the main zone. Accordingly, each of the signal traces connected to components on the first outer layer may be separated from the one or more heater terminals by at least the separation distance. As a result, a likelihood of signal interference or short circuits resulting from proximity to the heating system and/or residue leaking from the heating system of the aerosol generating device may be reduced.

The first outer layer may further comprise a first power trace and a second power trace for providing positive and negative power to the one or more heater terminals. The first and second power traces may extend from the main zone, through the keep-out zone, to the one or more heater terminals.

The first and second power traces may form the only copper, of the first outer layer, which is positioned in the keep-out zone. Thus, all of the selectively etched copper of the first outer layer in the keep-out zone may form the first and second power traces. Accordingly, copper of the first outer later which is inside the keep-out zone and external to the first and second traces may be etched away (i.e., absent). Solder resist of the first outer layer which is in the keep out zone and which is external to the first and second power traces may be deposited directly onto an insulating substrate of the PCB.

The first and second power traces may each have a minimum width (e.g., a minimum trace thickness) of at least 0.5mm, at least 1mm, at least 1.5mm, or at least 2mm in the keep-out zone. The thickness of the power traces facilitates delivery of sufficient current to the one or more heater terminals and the heating system for heating an aerosol precursor.

The PCB may comprise one or more switching elements (e.g., first and second switching elements) for enabling and disabling current flow through the first and/or second power traces. The switching elements may be controllable by a processor for performing phase control of the heater so as to adjust a temperature of the heating element. The switching elements may be MOSFETs. For example, the switching elements may be power MOSFETs which may have a current rating of 1A or more.

The one or more switching elements may be separated from the one or more heating terminals by at least the separation distance. For example, the one or more switching elements may be located in the main zone of the first outer layer. The one or more switching elements may be positioned near to the keep-out zone to minimise a distance of the current path between the one or more heater terminals and the one or more switching elements. That is, the one or more switching elements may be separated from the one or more heater terminals by no more than 30mm, no more than 25mm, or no more than 20mm.

The PCB may have an elongate shape. A longitudinal axis of the PCB may extend from a first end of the PCB to a second end of the PCB. The elongate shape may enable the PCB to fit into an aerosol generating device with a corresponding elongate shape which is more convenient to hold and use than other shapes of device. Further, the elongate shape may facilitate a layout if the PCB in which power connections, such as the one or more power terminals and the one or more heater terminals, can be spatially distance from any external connectors, such as a charging connector as described below, which may cause the PCB to be exposed to dust or moisture from the external environment.

The one or more heater terminals may be positioned proximally to the first end of the printed circuit board so that, when the printed circuit board is positioned in the aerosol generating device, the one or more heater terminals are connectable to the heating system. Proximally may be understood to mean that the one or more heater terminals are positioned closer to the first end than the second end. The one or more heater terminals may be positioned within 3mm of the first end of the printed circuit board. Accordingly, the one or more heater terminals may be separated from the first end of the PCB by no more than 5mm, no more than 3mm, or no more than 2mm.

The first keep-out zone surrounding the one or more heater terminals may include an end portion of the PCB which extends from the first end towards the second end. The end portion of the PCB occupied by the keep-out zone may fully extend from a first side of the PCB to a second side of the PCB, the first and second sides connecting the first and second ends of the PCB. The end portion may extend from the first end towards the second end by at least 3mm, at least 4mm, at least 5mm, or at least 6mm. Therefore, any components, traces, or copper pours in the main zone of the first outer layer may be separated from the first end of the PCB by the keep-out zone. Accordingly, a likelihood of residue from the heating system building up around such features and causing overheating of the PCB may be reduced.

As mentioned above, the PCB may further comprise a charging connector for receiving power for charging the power source. The charging connector may be mounted to the first outer layer in the main zone. The charging connector may overhang the second end of the PCB. The charging connector may be positioned at least 20mm, at least 30mm, or at least 40mm from the one or more heater terminals and/or the one or more power terminals. The charging connector may be configured to interface with an external environment of the aerosol generating device. Therefore, by separating the charging connector from the power terminals a likelihood of the power terminals, which for example may be battery terminals, being exposed to dust and/or moisture from the environment is reduced.

The one or more power terminals may be positioned closer to the one or more heater terminals than the second end of the PCB. For example, the one or more power terminals may be located no more than 20mm, no more than 15mm, or no more than 12mm from the one or more heater terminals. Positioning the one or more power terminals and heater terminals in this way can help to ensure there is a short switching path for power being provided to the one or more heater terminals which can reduce interference, and current losses in the switching path.

The PCB may comprise a second outer layer. For example, the first outer layer may be referred to as the top layer and the second outer layer may be referred to as the bottom layer. The second outer layer may comprise a second keep-out zone and a second main zone.

Each of the features discussed above in relation to the first keep-out zone and the first main zone may apply to the second keep-out zone and the second main zone. For example, the second outer layer may comprise one or more copper pours wherein each of the one or more copper pours of the second outer layer may be located in the second main zone. All of the copper pours of the second outer layer may be located in the second main zone. Accordingly, the second keep-out zone may be absent of copper pours. Further, the second keep-out zone may be absent of signal traces.

Herein, a planar face of the PCB may be considered to be a horizontal plane, wherein each of the layers of the PCB may be stacked on top of each other, in a vertical direction along a vertical plane.

The second keep-out zone may be located below the first keep-out zone. Accordingly, a position of the second keep-out zone (relative to a planar face of the PCB) may overlap with or correspond to the first keep-out zone. In some examples, the second keep-out zone may have a same size and shape as the first keep-out zone. The second keep-out zone may occupy a same planar position as the first keep-out zone. Accordingly, the first and second keep-out zones may occupy a same portion of the PCB, proximal to the first end.

The second main zone may be located below the first main zone. Accordingly, a position of the second main zone, relative to a planar face of the PCB, may overlap with or correspond to the second keep-out zone. In some examples, the second main zone may have a same size, shape, and planar position as the first main zone.

The one or more power input terminals may comprise one or more solder pads positioned on the second outer layer of the PCB. The one or more power input terminals may be positioned in the second main zone. The one or more power input terminals may be located no more than 30mm, no more than 25mm, no more than 20mm from the one or more heater terminals. The one or more power input terminals may comprise a positive terminal and a negative or ground terminal.

The PCB may comprise one or more inner conductive layers. For example, the PCB may comprise four or more conducting layers, including the first outer layer, the second outer layer, and two or more inner conductive layers (including a first inner layer and a second inner layer). The conductive layers may be vertically stacked and separated by one or more insulating layers. Each of the first and second outer layers may be coated in solder mask. Each of the four or more conducting layers may be a selectively etched copper plane for providing one or more signal traces and/or copper pours on that layer.

The one or more inner conductive layers may each comprise an inner copper pour. The inner copper pour may form a ground or power plane. For example, the inner copper pour may be electrically connected to electrical ground or power of the PC. The inner copper pour may extend underneath the first keep-out zone, and, when present, above the second keep-out zone. Therefore, the one or more inner layers may comprise one or more copper pours (e.g., power planes) located between the first and second keep-out zones. For example, the inner copper pour may cover a majority of a surface area of the respective inner layer.

The one or more the inner layers may comprise one or more signal traces in a position corresponding to (e.g., vertically below) the first keep-out zone. All signal traces, which are in addition to the first and second power traces, and connected to a component located in the first or second keep-out zones may be provided in one or more of the inner layers. By confining signal traces which must be routed to the first or second keep-out zones to an inner layer, a likelihood of the signal traces being exposed to unintended thermal effects of a residue incident on the PCB may be reduced.

For example, the PCB may comprise a sensing component mounted to the second outer layer of the printed circuit board. The sensing component may be a magnetic sensor, for example, for sensing a presence of a cap of the aerosol generating device. Accordingly, the sensing component may be mounted proximally to the first end of the PCB (within an area of the first keep-out zone) such that, when the PCB is installed in an aerosol generating device, the sensing component is within a sensing range of the cap.

The sensing component may be a through-hole mounted component. Accordingly, the sensing component may comprise a terminal pin extending through the PCB. The terminal pin may extend through the PCB to the first keep-out zone of the first outer layer. Accordingly, the sensing component may be mounted to the PCB in a position corresponding to the first keep-out zone, for example, in the second keep-out zone. The terminal pin of the sensing component may be connected to one of more sensor signal traces. The one or more sensor signal traces may be located in the one or more inner conductive layers of the printed circuit board. In this way, the one or more sensor signal traces need not be routed through the first or second keep-out zones.

As mentioned above, the first outer layer may comprise a solder mask sublayer deposited onto the selectively etched conductive plane. Additionally, the first outer layer may comprise silkscreen deposited onto the solder mask sublayer.

In some examples, the first outer layer may comprise a silkscreen buffer between the one or more heater terminals and the main zone. The silkscreen buffer may be a continuous portion of silkscreen extending from the one or more heater terminals to the perimeter between the first main zone and the first keep-out zone. The silkscreen buffer may have a width (e.g., measured parallel to the longitudinal axis of the PCB) of at least the separation distance between the one or more heater terminals and the main zone, for example, at least 2mm. The presence of the silkscreen buffer in addition to the solder mask reduces a likelihood of solder or residue from the heating system sticking to and building up around the heater terminals.

The second outer layer may comprise a silkscreen buffer (e.g., a second silkscreen buffer) between the second keep-out zone and one or more of the power input terminals. The second silkscreen buffer may surround at least two, or at least three sides of a first of the one or more power input terminals. The second silkscreen buffer may be a continuous portion of silkscreen located in an area between the first power input terminals and the second keep-out zone. In particular, when the one or more power input terminals include a power terminal and a ground terminal (connected to electrical ground of the PCB) the second silkscreen buffer may surround at least three sides of the power terminal. A minimum thickness of the second silkscreen buffer may be at least 0.5mm, or at least 0.8mm. The second silkscreen buffer may help to prevent solder or aerosol residue from building up around the one or more power terminals.

In a further aspect, there is provided an aerosol generating device comprising the printed circuit board of the previous aspect and a heating system for heating an aerosol precursor. The heating system may receive power from the one or more heater terminals of the PCB.

The heating system may be separated from the PCB by an interior wall of the aerosol generating device. The interior wall may comprise an aperture, wherein the one or more heater terminals may be connected to the heating system via one or more wires extending through the aperture. The aerosol generating device may comprise one or more seals positioned around the one or more wires for sealing the aperture. The one or more seals may help to impede residue from the heating system, such as the aerosol precursor or aerosol biproducts, from leaking towards the PCB via the aperture.

The aerosol generating device may be a heat-not-burn (HNB) device. Accordingly, the aerosol precursor may be a solid precursor, and the heating system may comprise a heating element for penetrating the aerosol precursor. In other examples, the aerosol generating device may be an electronic vapour product (EVP), also known as a vaping device or a vape. In this example, the device may be configured to receive an aerosol precursor (e.g. a liquid or gel) which is aerosolised by an aerosol-generating unit, such as a heating element or ultrasonic element.

In a further aspect, there is provided an aerosol generating system comprising the aerosol generating device of the previous aspect and a consumable comprising an aerosol generating precursor.

The preceding summary is provided for purposes of summarizing some examples to provide a basic understanding of aspects of the subject matter described herein. Accordingly, the above-described features should not be construed to narrow the scope of the subject matter described herein in any way. Moreover, the above and/or following examples may be combined in any suitable combination to provide further examples, except where such a combination is clearly impermissible or expressly avoided. Other features, aspects, and advantages of the subject matter described herein will become apparent from the following text and the accompanying figures.

### BRIEF DESCRIPTION OF THE FIGURES

Aspects, features and advantages of the present disclosure will become apparent from the following description of examples in reference to the appended figures in which like numerals denote like elements.
Figure 1 shows an example of an aerosol-generating system;
Figure 2 shows the components of the aerosol-generating system in a 'disengaged state';
Figure 3 shows the components of the aerosol-generating system in an 'engaged state';
Figure 4 shows a diagram of a PCB for the aerosol-generating system;
Figure 5 shows an example layer stack of the PCB;
Figure 6 shows a layout of a top layer of the PCB;
Figure 7 shows a magnified view of the top layer;
Figure 8 shows a layout of a first inner layer of the PCB;
Figure 9 shows a magnified view the first inner layer;
Figure 10 shows a layout of a second inner layer of the PCB;
Figure 11 shows a magnified view the second inner layer;
Figure 12 shows a layout of a bottom layer of the PCB;
Figure 13 shows a magnified view of the bottom layer;
Figure 14 shows a computer aided design (CAD) model of the top side of the PCB: and
Figure 15 shows a CAD model of the bottom side of the PCB.

### DETAILED DESCRIPTION OF EMBODIMENTS

It is to be understood that the present disclosure, which includes the specification and claim(s), is not limited by specific construction details or process steps. Rather, it will be clear to those skilled in the art that the devices, systems, and methods described herein can be embodied and practiced in various alternative ways without departing from the scope of the invention.

Unless defined otherwise, scientific and technical terms used herein have their meanings commonly understood by those skilled in the art and that known techniques and procedures may be performed according to conventional methods.

In the present disclosure, the terms "a" and "an" may mean "one", "one or more", "at least one", and "one or more than one" unless the context clearly indicates otherwise. Likewise, plural terms shall include the singular unless otherwise required by context.

In the present disclosure, the term "or" means an inclusive "and/or" unless explicitly indicated to refer to alternatives only or unless the alternatives are mutually exclusive.

In the present disclosure, the terms "comprising, "having," "including," or "containing" (and any forms thereof, such as "comprise" and "comprises," "have" and "has," "includes" and "include," or "contains" and "contain," respectively) are inclusive or open-ended and do not exclude additional, unrecited elements or method steps.

Unless stated otherwise, the features of examples disclosed herein, and of the claims, may be integrated together in any suitable arrangement such that combinations of features are not limited by the described forms, particularly the form (e.g. numbering) of example(s), embodiment(s), or dependency of claim(s). This also applies to the phrase "in one example", "according to an example" and the like, which are merely a stylistic form of wording not to be construed as limiting the features to a separate embodiment. This is to say, a reference to 'an,' 'one,' or 'some' examples(s) may be a reference to any one or more, and/or all examples, or combination(s) thereof, disclosed. Also, similarly, reference to "the" example may not be limited to the immediately preceding embodiment. Further, all references to one or more embodiments or examples are to be construed as non-limiting to the claims.

The present disclosure may be better understood in view of the following explanations, wherein the terms used that are separated by "or" may be used interchangeably.

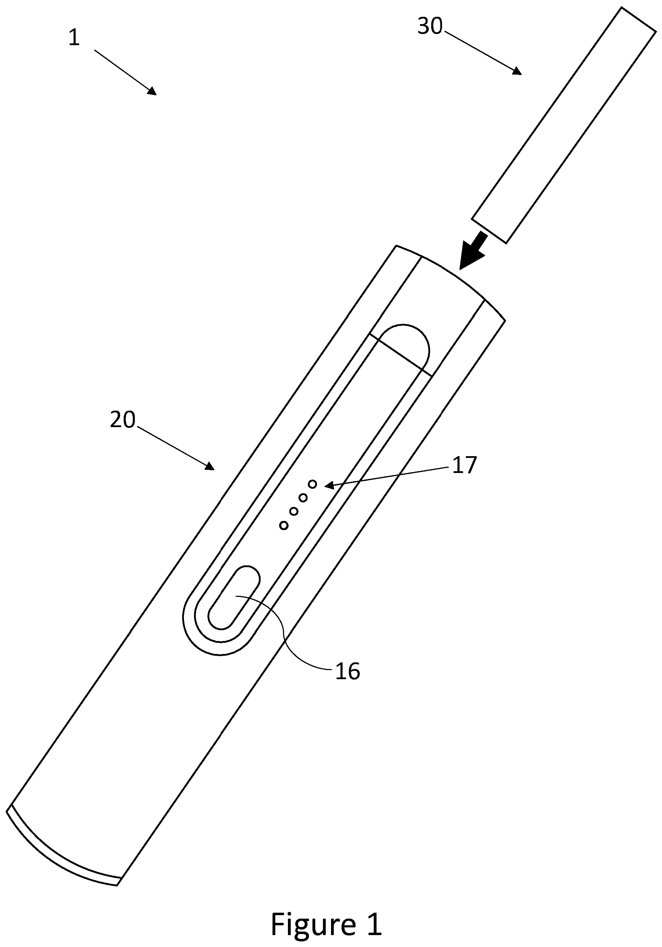

Figure 1 shows an example of an aerosol-generating system 1 comprising a device body 20 and an article 30 (alternatively referred to as a "consumable") for insertion into the device body 20. In this example, the device body 20 is a heat-not-burn device (HNB) configured to produce an aerosol by heating an aerosol-forming material 10 (e.g. a solid precursor, such as tobacco material) to a temperature below its combustion temperature, although it will be appreciated that the invention may be similarly applicable to an electronic vapour product (EVP) configured to produce an aerosol from an aerosol-forming material (e.g. a liquid or gel precursor).

The term "aerosol-forming material" refers to a material capable of releasing volatile components that can form an aerosol, e.g. by releasing volatile compounds in the aerosol-forming material 10. An "aerosol" is a dispersion of solid particles and/or liquid droplets dispersed in a gas. The aerosol may be visible or invisible.

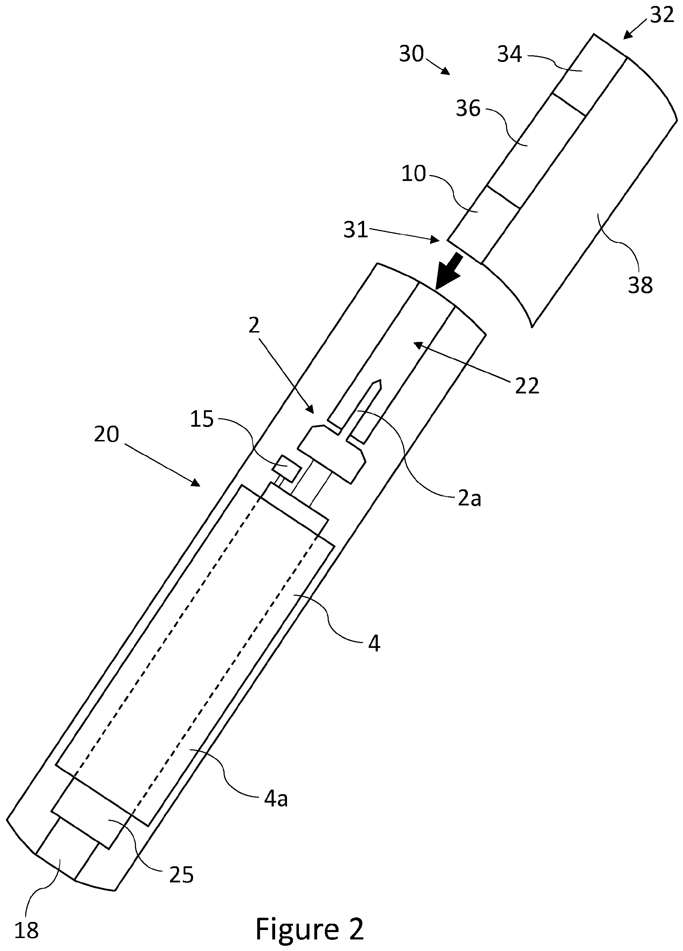

Figure 2 shows a schematic representation of the internal components of the device body 20 and article 30. The device body 20 and article 30 are shown in a "disengaged state" in which the article 30 is separated from the device body 20.

The aerosol-generating system 1 has an aerosol-generating unit 2 in the form of a heating system. The heating system comprises a heating element 2a configured to penetrate the article 30. The heating element 2a, which may also be referred to as a heater, is configured to heat the aerosol-forming material 10 to a temperature lower than its combustion temperature such that an aerosol can be formed by evaporation, torrefaction and pyrolysis.

The aerosol-generating system 1 includes a power source 4. In this example, the power source 4 includes a battery 4a configured to supply electrical energy to operate the aerosol-generating unit 2 and other components. The aerosol-generating system 1 may be powered, alternatively or in addition to the battery 4a, by an external power source.

The article 30 defines an air passageway which transmits aerosol generated from the aerosol-forming material 10 to a downstream end 32 (i.e. terminal end or mouth end) of the article 30. The article 30 may comprise one or more filter elements 34, one or more spacer elements 36, and one or more wrapping layers 38 (e.g. paper, foil or composite layers). One or more of the filter elements 34 and spacer elements 36 may define the air passageway. In the present example, the article 30 comprises an aerosol-forming material 10 at the upstream end 31 of the article 30, a filter element 34 at the downstream end 32, and a spacer element 36 positioned between them, all circumscribed by a wrapping layer 38.

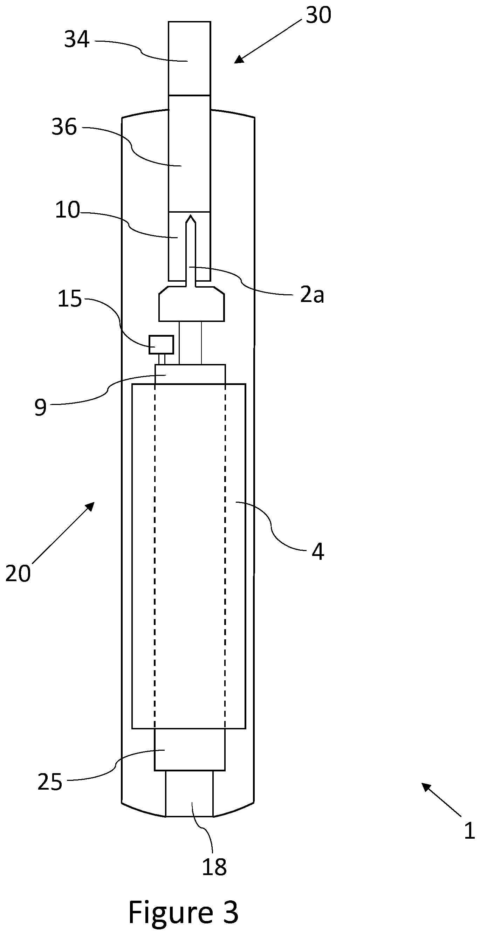

Figure 3 shows the aerosol-generating system 1 in an "engaged state" in which the article 30 is inserted into an internal chamber 22 of the device body 20.

In this example, the heating element 2a is configured to penetrate the article 30. The heating element 2a is arranged to extend along a length of the aerosol-forming material 10 when inserted therein, such that when the heating element 2a is activated, heat is transferred radially outward from the heating element 2a to the aerosol-forming material 10 resulting in formation of an aerosol. This may be referred to as an 'inside-out' heating arrangement. The aerosol is subsequently entrained in an airflow produced by the action of the user drawing on the downstream end 32 of the article 30.

In alternative examples, the heating element 2a may be configured to at least partially encircle the article 30, such that when the heating element 2a is activated, heat is transferred radially inward from the heating element 2a to the aerosol-forming material 10. This may be referred to as an 'outside-in' heating arrangement.

In this example, the heating element 2a is a resistive heating element although it will be appreciated that the aerosol-forming material 10 may be heated by any suitable means. For instance, the heating element 2a may comprise a susceptor (not shown) configured to produce heat when penetrated by an alternating magnetic field.

The device body 20 may include any one or more of electrical circuitry, a memory, a wireless interface, and one or more other components. The device body 20 includes a printed circuit board (PCB) 25 on which components of the electrical circuitry, memory, wireless interface, and other components may be mounted.

The electrical circuitry may include a processing resource for controlling one or more operations of the body 20 and article 30, e.g. based on instructions stored in the memory. The wireless interface may be configured to communicate wirelessly with an external (e.g. mobile) device, e.g. via Bluetooth. The other component(s) may include one or more user interface devices configured to convey information to a user, a pressure sensor 15, and/or a charging port 18.

The aerosol-generating system 1 may comprise one or more input and/or output elements. The input and/or output elements may form part of a user interface (UI) of the system 1. For instance, figure 1 shows an input element in the form of a button 16 and an output element in the form of a set of lights (LEDs) 17. The button 16 is configured to control at least one function of system 1, such as power supply to the heating element 2a. The lights 17 are configured to convey information to the user regarding the state of the system 1 and/or article. It will be appreciated that the input element(s) may be provided in various forms such as touch screens, switches, and sensors, and the output element(s) may be provided in various forms such as display screens, speakers, or a haptic output generated by a vibration generator.

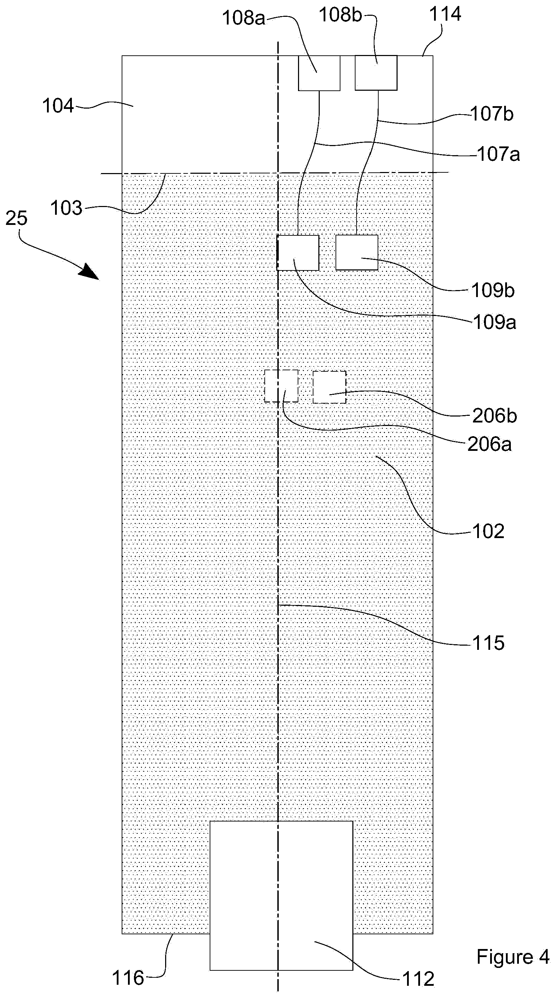

Figure 4 show a diagram of a PCB 25 for installation in the device body 20. The PCB 25 comprises a top side and a bottom side upon which electrical components are mounted and connected together via signal traces and copper pours to form an electrical circuit. In Figure 4, components which are mounted to the top side are shown with solid lines and components mounted to the bottom side are shown using dashed lines. The PCB 25 has an elongate shape having a longitudinal axis 115 extending from a first end 114 of the PCB 25 to a second end 116.

The PCB 25 additionally comprises a positive power input terminal 106a and a negative power input terminal 106b for receiving power from the power source 4, first and second heater terminals 108a, 108b for providing power from the power input terminals 206a, 206b to the heating system, and first and second switching elements 109a, 109b which are configured to enable and disable the power provided to the heater terminals 108a, 108b in order to perform pulsed temperature control of the heating system.

In the examples discussed herein, the power source is a battery 4a. The positive and negative power input terminals 206a, 206b are surface-mount solder pads of the PCB 25 for connection the battery 4a via wires or a connector. The power input terminals 206a, 206b are located on the bottom side of the PCB 25 for more convenient access to the battery 4a. The first and second heater terminals 108a, 108b are through-hole terminals of the PCB 25 for receiving a connector or wires connected to the heating system. In other example, the first and second heater terminals 108a, 108b may be surface mount solder pads of the PCB 25. The switching elements 109a, 109b are power MOSFETs controllable by a processor (not shown).

Also provided is a charging connector 112 for receiving power from an external power source for charging the battery 4a. The charging connector 112 overhangs the second end 116 of the PCB 25. In contrast, the first and second power input terminals 206a, 206b are positioned closer to the first end 114 of the PCB 25 than the second end 114 to reduce a likelihood of the power input terminals 206a, 206b being exposed to any moisture or dust which may penetrate the device body 20 via the charging connector 112.

The top layer of the PCB 25 is divided into a main zone 102 (shown in grey on Figure 4) and a keep-out zone 104 which surrounds the first and second heater terminals 108a, 108b. The keep-out zone 104 is defined during a layout process of the PCB design to prevent the placement of unspecified signal tracks or copper pours in the keep-out zone 104. Accordingly, each copper pour (not shown) of the top layer of the PCB 25 is located in the main zone 25. A perimeter 103 between the main zone 102 and the keep-out zone 104 therefore forms a border of one or more of the copper pours so that no copper pours extend into the keep-out zone 103.

The keep-out zone covers a portion of the PCB which extends from the first end 114 towards the second end 116 by a width 118 of at least 3mm, more preferably at least 5mm. A separation distance 116 between the first and second heater terminals 108a, 108b and the main zone 102 is at least 2mm.

The keep-out zone 104 on the top layer comprises the first and second heater terminals 108a, 108b, and first and second power traces 107a, 107b which extend from the switching elements 109a, 109b in the main zone, through the keep-out zone 104, to the heater terminals 108a, 108b. The first and second heater terminals 108a, 108b are positioned so that the separation distance between the first and second heater terminals 108a, 108b and the main zone 104 is at least 2mm. All other components mounted to the top layer of the PCB 25, copper pours, and signal traces on the top layer are confined to the main zone 102.

The presence of the keep-out zone 104 around the first end 114 of the PCB 25 helps to prevent build-up of leaked residue from the heating system around the electrical components in the event that the device is subject to heavy use. In particular the reduction of copper in the keep-out zone, owing to the absence of copper pours (e.g., the absence of a ground plane), helps to prevent the conduction of undesirable heat from the heating system to the rest of the components and solder pads on the PCB 25.

The first and second power traces 107a, 107b have a thickness of at least 2mm to provide sufficient current to the heater terminals 108a, 108b. It is desirable to provide a short switching path between the switching elements and the heater terminals to reduce interference on the power traces 108a, 108b and to other components on the PCB 25 as well as to avoid inefficiencies due to the increased resistance of longer signal tracks. Accordingly, the switching elements 109a, 109b are located relatively close to the heater terminals 108a, 108b (e.g., within 30mm), but still outside of the keep-out zone 102 to prevent potential residue build-up around the switching elements 106a, 106b which could cause them to overheat.

The PCB 25 is separated from the heating system by an interior wall (not shown) of the device body 20. The interior wall comprises an aperture and the heater terminals 108a, 108b are connected to the heating system via first and second wires or rigid connectors extending from the heater terminals 108a, 108b through the aperture to the heating system. The aerosol generating device 20 may comprise one or more seals positioned around the wires or connectors for sealing the aperture. The one or more seals may help to impede residue from the heating system from leaking towards the PCB 25 via the aperture.

Features discussed herein in relation to Figure 4 have like reference numbers in each of the following figures.

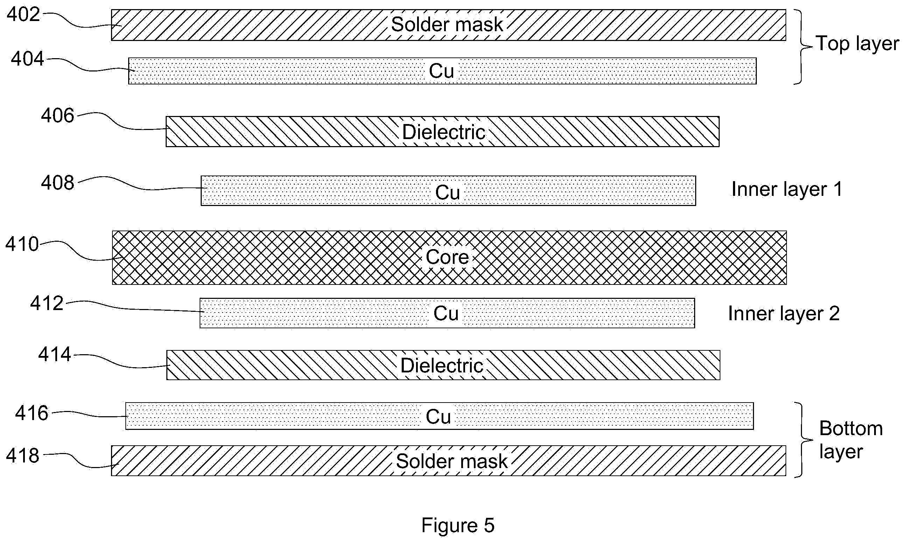

Figure 5 shows an example layer stack of the PCB 25. The PCB 25 comprises four conductive layers formed of copper foil and so may be referred to as a four-layer PCB. The PCB 25 comprises an insulating core 410 upon which additional layers are deposited. A first inner conductive layer 408, formed of selectively etched copper foil, is deposited on the core 410. Signal traces may be provided in the first inner layer as well as copper pours to form power or ground planes by selectively etching the copper. A second inner conductive layer 412, formed of selectively etched copper foil, is deposited on a lower side of the core 410. Next, insulating layers 406, 414 formed of a dielectric are deposited on the first and second inner conductive layers 408, 412 to isolate them from additional conductive layers.

Next, a top layer comprising a conductive plane 404 formed of selectively etched copper foil and covered in solder mask 402 is deposited on the upper insulating layer 406. Additionally, a bottom layer comprising a second conductive plane 416 formed of selectively etched copper foil covered in solder mask 418 is deposited on the lower insulating layer 414. The upper and lower conductive planes 404, 405 are selectively etched to provide signal traces and copper pours for connecting components which are mounted to the top and bottom layers of the PCB 25. Each of the conductive layers 404, 408, 412, 416 may be connected to each other using plated vias (not shown).

Although a four layer PCB is shown, other configurations may be used in conjunction with the techniques discussed herein. For example, additional inner layers separated by additional insulating layers may be provided to increase the number of layers of the board or fewer conductive layers may be used. Further, although copper is described throughout this disclosure as forming the conductive layers, the PCB 25 may alternatively or additionally comprise one or more conductive layers formed of a different conductive material such as aluminium.

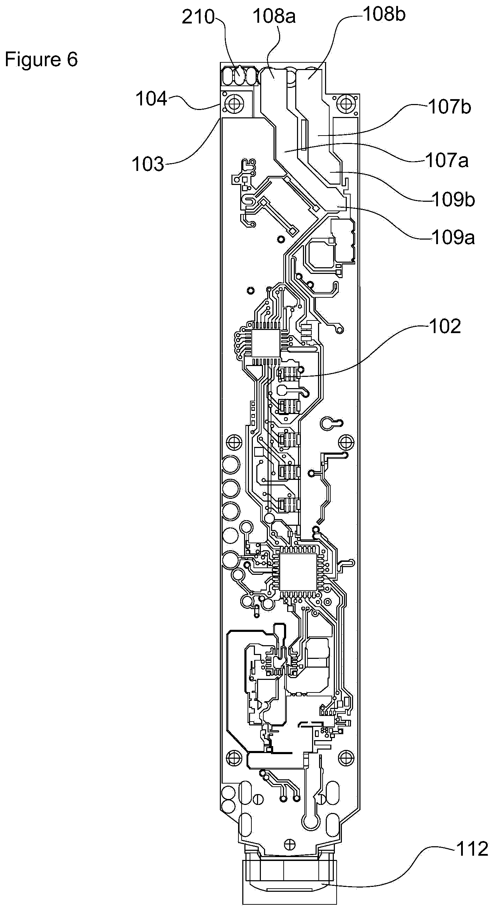

Figure 6 shows an example layout of a top layer of the PCB 25 which shows signal traces connecting each component of the top layer to each other and copper pours which fill regions of the top layer in-between the signal traces. Each of the copper pours is connected to electrical ground or power to form a power plane.

As shown in Figure 6, the copper pours are absent from a keep-out zone 104 extending from the first end 114 of the PCB 25. In this example, the keep-out zone extends from the first end towards the second end of the PCB 25 by a width 118 of approximately 6mm. The keep-out zone has a maximum length from side-to-side of the PCB 25 of approximately 15 mm. In Figure 6 the first and second heater terminals 108a, 108b are hidden underneath the first and second power traces 107a, 107b providing power from the first and second switching elements 109a, 109b to the first and second heater terminals 108a, 108b.

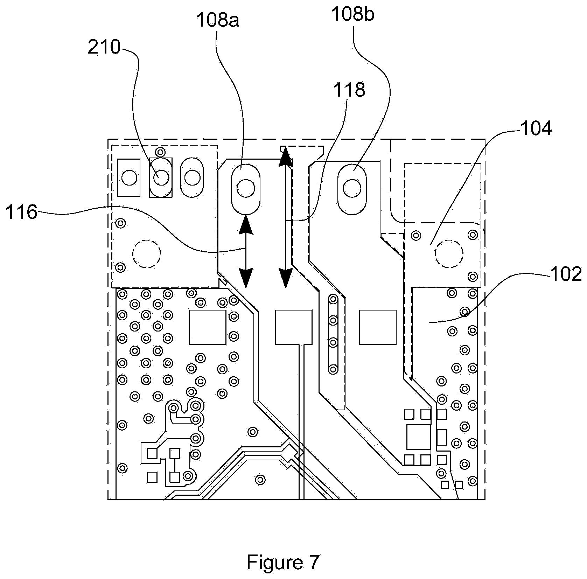

Figure 7 shows a magnified view of the top layer of the PCB 25 in which solder pads and vias are visible. In this example, the first and second heater terminals 108a, 108b are through-hole terminals for receiving wires or pins of a connector to connect to the heating system. Accordingly, the first and second heater terminals 108a, 108b extend through the board to the bottom layer. A separation distance 116 between the first and second heater terminals 108a, 108b and the main zone is at least 2mm, more preferably at least 2.5mm. In this example, a width 118 of the keep-out zone, measured parallel to the longitudinal axis 115 of the PCB 25, is 6mm.

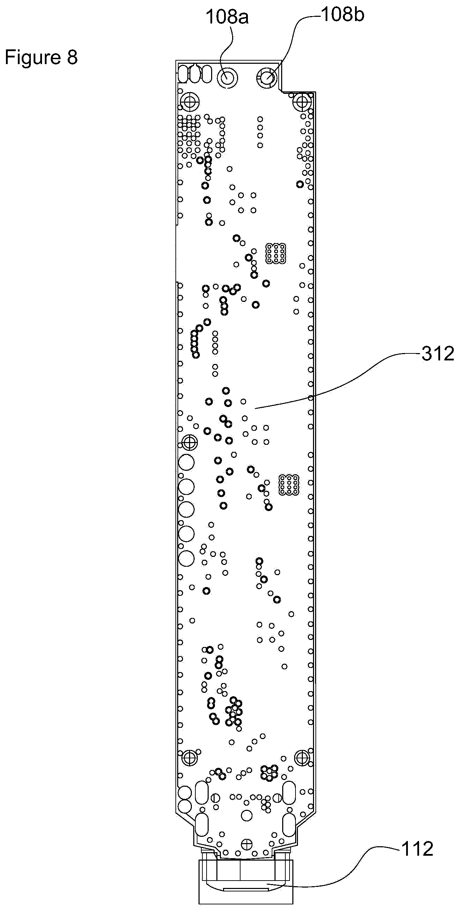

Also shown in Figure 7 additional through-hole terminals 210 for receiving pins of a sensing component mounted to the bottom layer of the PCB 25 are also present in the keep-out zone 104. The sensing component is a Hall sensor for detecting the position of a cap of the device body 20. The additional through-hole terminals 210 are located in the keep-out zone 104 so as to position the sensing component proximally to the cap. However, signal traces for connecting to the sensing component are prevented from being routed through the keep-out zone 104. All signal traces 211 for connecting to the sensing component are provided in an inner layer of the PCB 25 to reduce a presence of signal traces in the keep-out zone 104. Accordingly, as shown in Figure 8, the only copper provided in the keep-out zone 104 of the top layer forms the first and second power traces 107a, 107b for providing power to the first and second heater terminals 108a, 108b.

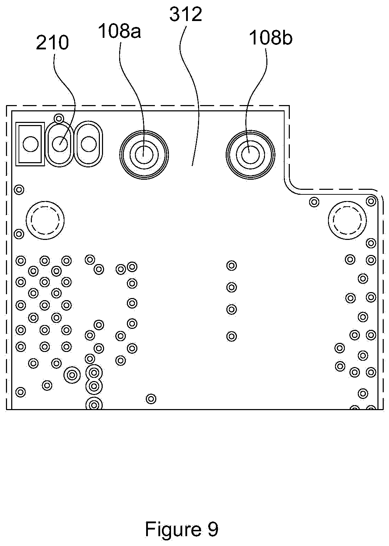

Figure 8 shows an example layout of a first inner layer of the PCB 25. Figure 9 shows a magnified view the first inner layer in a location corresponding to the keep-out zone 194 of the top layer. The first inner layer comprises a copper pour 312 connected to electrical ground or power to form a power plane. The power plane extends underneath the keep-out zone 104 of the top layer. Accordingly, the power plane extends across the entire surface area of the first inner layer. The power plane is separated from borders of the PCB 25 and from vias of the PCB 25 which are connected to a different electrical net, by a standard stand-off distance which is no more than 0.8mm. However, the first inner layer does not include a keep-out zone as on the top layer since, for example, there is no stand-off distance between copper regions of the first inner layer which is larger than 3mm as required for the keep-out zone 104 of the top layer.

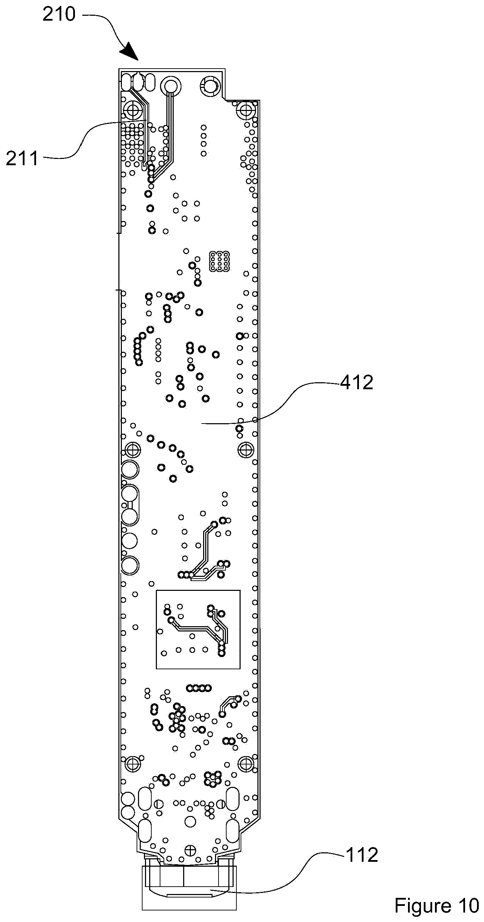

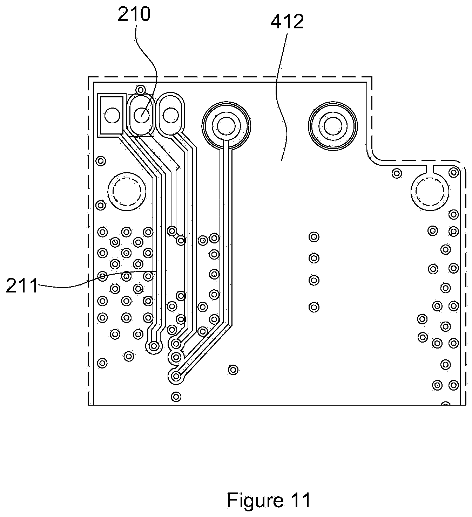

Figure 10 shows an example layout of a second inner layer of the PCB 25. Figure 11 shows a magnified view the second inner layer in a location corresponding to the keep-out zone 104 of the top layer. The second inner layer also comprises a copper pour 412 connected to electrical ground or power to form a power plane. The power plane of the second inner layer extends underneath the keep-out zone 104 of the top layer to extend across the entire surface area of the second inner layer. Additionally the second inner layer comprises sensor signal traces 211 extending underneath the keep-out zone for providing and receiving signals from the through-hole terminals of the sensing component 210.

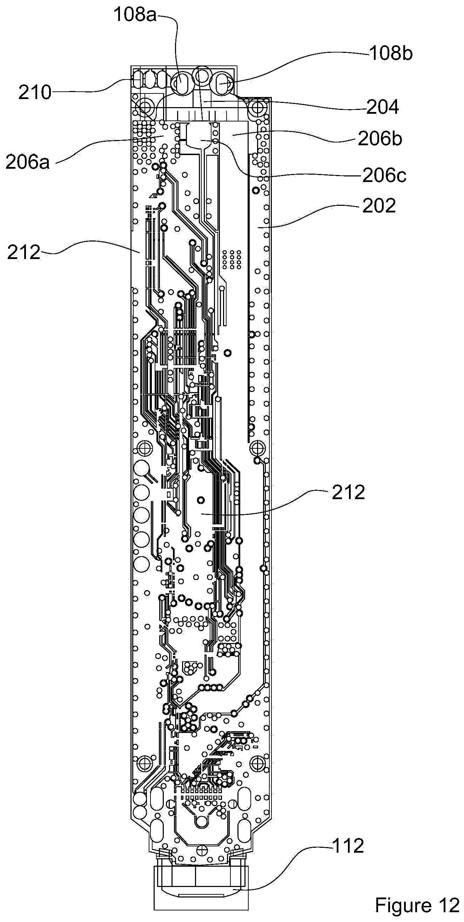

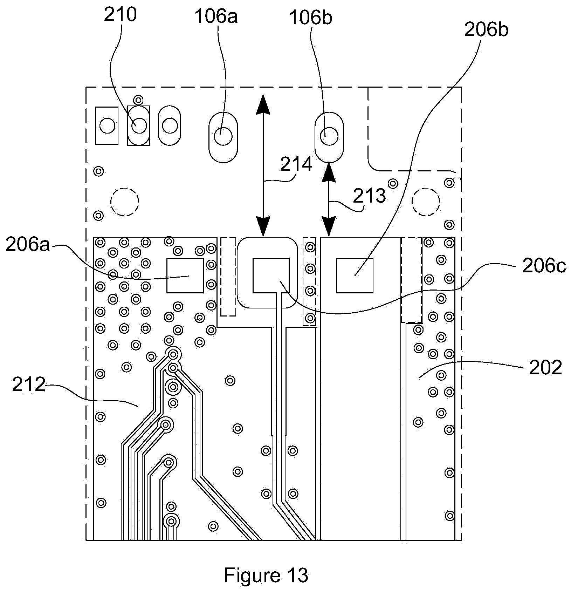

Figure 12 shows an example layout of a bottom layer of the PCB 25. Figure 13 shows a magnified view of the bottom layer in a location corresponding to the keep-out zone 104 of the top layer.

The bottom layer comprises a second keep-out zone 204 located vertically below the first keep-out zone 104 of the top layer. The second keep-out zone 204 has a same shape as and is located in the same position as the first keep-out zone 104. Accordingly, the second keep-out zone 204 covers a portion of the PCB 25 which extends from the first end 114 towards the second end 116 by a width 214 of at least 3mm, more preferably at least 5mm. The remainder of the bottom layer can be referred to as a second main zone 202 which is vertically below the first main zone 102 of the top layer. A separation distance 213 between the first and second heater terminals 108a, 108b, which extend through the PCB 25 to the bottom layer, and the second main zone 202 is at least 2mm, more preferably at least 2.5mm.

As shown in Figure 12 the bottom layer comprises at least one copper pour 212 located in the main zone 202. All copper pours 212 and signal traces of the bottom layer are located in the main zone 202. Accordingly, the copper pours 212 are partially delineated by a perimeter dividing the keep-out zone 204 and the main zone 202 as shown in Figure. 12.

As mentioned above, additional terminals 210 for a sensing component is provided in the second keep-out zone 204 of the bottom layer. Signal traces 211 for connecting to the sensing component are provided in an inner layer (as discussed above) to avoid routing signals through the second keep-out zone 204.

The first and second power input terminals 106a, 106b are provided as surface-mount solder pads in the main zone 202 of the bottom layer as shown in Figure 13. Also provided is a third terminal 206c for receiving a temperature sensing signal from the battery 4a. The first, second, and third terminals 206a-c may be connected to the battery by wires soldered directed to the terminals or via a connector installed on the terminals.

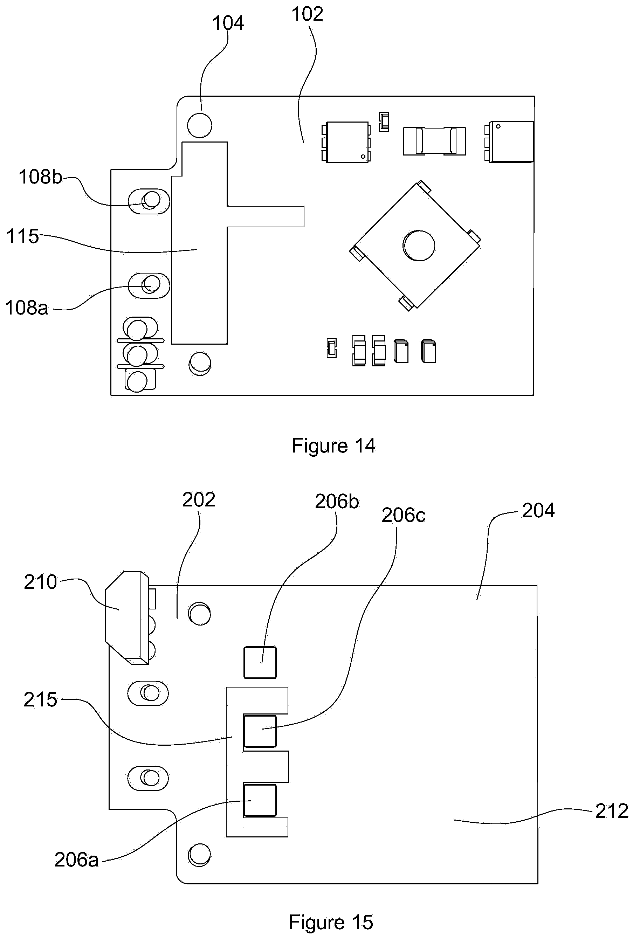

Figure 14 shows a CAD model of the top side of the PCB 25 including solder pads, silkscreen and mounted components. A silkscreen buffer region 115 is provided in an area between the first and second heater terminals and the main zone. The silkscreen buffer region 115 therefore forms a boundary between the heater terminals 108a, 108b and the copper pours, signals traces (other than the first and second power traces 107a, 107b), and components of the top side of the PCB 25. The silkscreen buffer region 115 is a continuous portion of silkscreen extending from the one or more heater terminals 108a, 108b to the perimeter between the main zone 102 and the keep-out zone 104. The presence of the silkscreen buffer 115, in addition to the solder mask, reduces a likelihood of solder or residue from the heating system sticking to or building up around the heater terminals 108a, 108b.

Figure 15 shows a CAD model of the bottom side of the PCB 25 including the solder pads, silkscreen and mounted components, including the sensing component 210, the first and second power input terminals 2061, 206b, and the battery temperature input terminal 206c.

The bottom side includes a second silkscreen buffer region 215 filling an area between the second keep-out zone 204 and the first power input terminal 206a. In this example, the first power input terminal 206a is a power terminal connected to a power plane of the PCB 25 and the second power input terminal 106b is a ground terminal connected to electrical ground of the PCB 25. The second silkscreen buffer region 215 surrounds three sides of the first power input terminal 206a. Additionally, the second silkscreen buffer region 215 surrounds three sides of the temperature input terminal 206c. The second silkscreen buffer 215 may help to prevent solder and/or aerosol residue from building up around the power input terminals 106a-c which could cause overheating of that region of the PCB 25.

## Claims

1. A printed circuit board (PCB) for an aerosol generating device, the printed circuit board comprising:
one or more power input terminals for receiving power from a power source,
one or more heater terminals for providing the power from the power input terminals to a heating system of the aerosol generating apparatus,
wherein a first outer layer of the printed circuit board comprises a plurality of signal traces and one or more copper pours,
wherein the first outer layer comprises:
a first main zone comprising each of the one or more copper pours, and
a first keep-out zone surrounding the one or more heater terminals,
wherein the one of more copper pours are delineated by a perimeter between the first main zone and the first keep-out zone, and
wherein a shortest distance between the one or more heater terminals and the first main zone is at least 2mm.

2. The printed circuit board of claim 1 wherein no more than 70% of a surface area of the keep-out zone comprises copper.

3. The printed circuit board of any preceding claim wherein the first outer layer comprises one or more components for operating the aerosol generating apparatus, wherein each of the one or more components is located in the main zone.

4. The printed circuit board of claim 3 wherein the first outer layer comprises a plurality of signal traces for providing signals to the one or more components, wherein each of the plurality of signal traces is located in the main zone.

5. The printed circuit board of any preceding claim wherein the first outer layer further comprises a first power trace and a second power trace for providing positive and negative power to the one or more heater terminals, wherein the first and second power traces extend from the main zone, through the keep-out zone, to the one or more heater terminals.

6. The printed circuit board of claim 5 wherein the first and second power traces each have a minimum trace thickness of at least 2mm in the keep-out zone.

7. The printed circuit board of claim 6 further comprising first and second switching elements for enabling and disabling current flow through the first and second power traces, wherein the first and second switching elements are located in the main zone.

8. The printed circuit board of any preceding claim, wherein the printed circuit board has an elongate shape, wherein a longitudinal axis of the printed circuit board extends from a first end to a second end of the printed circuit board,
wherein the one or more heater terminals are positioned within 3mm of the first end of the printed circuit board, and
the first keep-out zone surrounding the one or more heater terminals includes an end portion of the printed circuit board which extends from the first end of the printed circuit board towards the second end by at least 5mm.

9. The printed circuit board of claim 8 further comprising a charging connector for receiving power for charging the power source, wherein the charging connector overhangs the second end of the printed circuit board.

10. The printed circuit board of any preceding claim wherein the printed circuit board comprises a second outer layer comprising one or more copper pours, a second keep-out zone located below the first keep-out zone, and a second main zone located below the first main zone, wherein each of the one or more copper pours of the second outer layer are located in the second main zone.

11. The printed circuit board of claim 10 wherein the power input terminals are solder pads positioned on the second outer layer of the PCB in the second main zone, wherein the one or more power input terminals are separated from the one or more heater terminals by no more than 30mm.

12. The printed circuit board of any preceding claim comprising one or more inner conductive layers wherein the one or more inner conductive layers comprise an inner copper pour forming a ground or power plane, wherein the inner layer copper pour extends underneath the first keep-out zone.

13. The printed circuit board of claim 12 wherein the printed circuit board comprises a sensing component mounted to a second outer layer of the printed circuit board, wherein the sensing component comprises a terminal pin, extending through the printed circuit board, to the first keep-out zone of the first outer layer,
wherein the terminal pin is connected to one or more sensor signal traces,
wherein the one or more sensor signal traces are located in the one or more inner conductive layers of the printed circuit board.

14. The printed circuit board of any preceding claim wherein the at least one outer layer comprises a continuous portion of silkscreen extending from the heater terminal to the perimeter between the first main zone and the first keep-out zone.

15. An aerosol generating device comprising the printed circuit board of any preceding claim, and a heating system for heating an aerosol precursor.
